# EUROPEAN PATENT APPLICATION

(11) **EP 1 248 333 A1**
(43) Date of publication of application: **09.10.2002**
(21) Application number: 01303129.9
(22) Date of filing: 02.04.2001
(51) Int. Cl.: H01S 3/131, H01S 5/0687

(54) **Wavelenght stabilised optical source**

(71) Applicant: Agilent Technologies, Inc. (a Delaware corporation), Palo Alto, CA 94303 (US)
(72) Inventor: Harker, Andrew Thomas, Ipswich IP4 5QF (GB)
(74) Representative: Coker, David Graeme

(57) **Abstract**

The invention relates to a method and a device for wavelength stabilisation of an optical source, particularly in Wavelength Division Multiplexing (WDM) systems. The device comprises a laser source (2), an interference filter (10), an array (14) of photodetectors (40,46), means (4) for controlling the wavelength of the laser, and a comparator (22). The interference filter (10) is illuminated (9) with optical radiation from the laser source (2) and projects a pattern of interference fringes (11) on the photodetector array (14). The pattern (11) changes according to the wavelength λ of optical radiation received (9) by the interference filter (10). At least two of the photodetectors (40,44) are used to generate corresponding signals (20,30), each of said signals varying depending on the intensity of the interference fringes (11) at the corresponding photodetector (40,46). The comparator (22) receives the signals (20,30), and generates a wavelength feedback control signal (32) that depends on wavelength λ. The array (14) includes at least three photodetectors (40-46), and the device (1) comprises means (18) for choosing a subset (40,44) of photodetectors from amongst the array (14) of photodetectors (40,46).

## Description

The invention relates to a method and a device for wavelength stabilisation of an optical source, particularly a laser diode for use with fibre-optic transmission systems that use Wavelength Division Multiplexing (WDM).

In optical systems it is often necessary to control accurately the wavelength of a laser source. This is of particular importance in fibre optic systems where a fibre carries multiple wavelengths from multiple laser sources.

This form of control is often achieved through the use of a wavelength locking device calibrated to the desired wavelength and forming part of the laser assembly. This device is arranged to measure the wavelength produced by a laser source and to provide a feedback control signal indicative of the error between the desired wavelength and the wavelength of the optical radiation produced by the source.

Such a locking device is disclosed in patent document US 5,825,792. Some of the output of the laser source is passed through an etalon to produce a pattern of interference fringes upon a pair of spaced-apart photodiodes. The output signals from these photodiodes are fed to a comparator, which produces a control signal to stabilise the wavelength of the laser output. This device is calibrated during manufacture by micro-manipulation of the angle of the etalon with respect to the laser and photodiodes. This adjusts the pattern of interference fringes illuminating the pair of photodiodes until output signals are achieved that will allow the comparator to send an appropriate control signal to the laser source if the wavelength shifts. After initial alignment, the etalon is secured in place, for example with a uv-curable adhesive.

This alignment process is time consuming and relatively expensive to implement. A skilled operator needs to use micro-manipulation tools to set the angle of the etalon with reference to signals from electronic test and measurement equipment, prior to adhering the etalon in place.

The embodiments described in patent document US 5,825,792 additionally include a lens which serves to control the divergence of the output beam of the laser source. This lens has to be precisely placed with respect to the laser to ensure that the pattern of interference fringes illuminates the pair of photodiodes correctly.

The present invention seeks to provide a more convenient wavelength stabilised optical device and a method for calibrating such a device.

According to the invention there is provided an optical wavelength control device, comprising a laser source, an interference filter, an array of photodetectors, means for controlling the wavelength of the laser, and a comparator, in which:
i) the interference filter is arranged to receive optical radiation from the laser source, and to project a pattern of interference fringes on the photodetector array, said pattern changing according to the wavelength of optical radiation received by the interference filter;
ii) the comparator receives from at least two of the photodetectors corresponding signals dependent on the pattern of interference fringes on said photodetectors, and generates therefrom a control signal that varies with the wavelength of the optical radiation;
iii) the means for controlling the wavelength of the laser is responsive to the control signal to stabilise the wavelength of the optical radiation;
characterised in that the array of photodetectors includes at least three photodetectors, and the device comprises means for choosing from amongst the array of photodetectors a subset of photodetectors from which the comparator receives said at least two corresponding signals.

This arrangement removes the requirement to align accurately the interference filter using micro-manipulation tools to alter the angle of the filter with reference to the photodetector array and removes the requirement to position accurately the optional lens with respect to the laser. The manufacture of this device is thus made easier and hence cheaper.

The photodetector array will most commonly have a planar arrangement of photodetectors. The photodetector array may be an integrated array of silicon photodiodes, each of which is capable of generating an electrical output that varies linearly with the intensity of optical radiation falling on the detector.

The term "optical radiation" is not limited to visible light, but includes in particular near infra-red optical radiation.

Preferably the subset of photodetectors consists of just two photodetectors. This reduces the complexity of the comparator required to generate the control signal and this leads to a reduction in the cost of production.

The interference filter may be an etalon or an interference grating. Both of these interference filters project patterns of interference fringes when illuminated by a source of optical radiation.

The production of the interference patterns with an etalon involves multiple internal reflections within the etalon creating constructive and destructive interference, which results in the pattern of interference fringes.

If an interference grating is used, this may be a reflective or transmissive grating.

A lens may be located in the optical path from the laser source to the interference filter to control the divergence of the laser source.

The lens and the interference filter may be combined in a unitary structure reducing the part count and manufacturing complexity. The combination of elements into a single structure may also facilitate integration of the device onto a chip.

According to the invention there is also provided a method for controlling the wavelength of an optical device, the device comprising a laser source, an interference filter, an array of photodetectors, means for controlling the wavelength of the laser, and a comparator, in which the method comprises the steps of:
a) illuminating the interference filter with optical radiation from the laser source to project a pattern of interference fringes on the photodetector array, said pattern changing according to the wavelength of optical radiation received by the interference filter;
b) using at least two of the photodetectors to generate corresponding signals, each of said signals varying depending on the intensity of the interference fringes at the corresponding photodetector;
c) providing at least two of said signals to the comparator, and generating with the comparator a control signal that is a measure of the interference pattern and hence the optical wavelength;
d) providing the control signal to the means for controlling the wavelength of the laser in order to stabilise the wavelength of the optical radiation;
   characterised in that the array of photodetectors includes at least three photodetectors, and the device comprises means for choosing a subset of photodetectors from amongst the array of photodetectors and the method includes the step of:
e) using the means for selecting from amongst the array of photodetectors to select said subset of photodetectors from which the comparator receives said corresponding at least two signals.

Step e) may be a permanent selection made during manufacture of the optical device setting the wavelength to which the output will be stabilised.

Preferably the relationship between the photodetector array and the interference pattern is such that different subsets of two or more photodetectors provide corresponding signals which, if selected to be provided to the comparator, result in a control signal that is appropriate for stabilising the wavelength of the optical radiation within different wavelength ranges.

It is possible that step e) may be a temporary step and that during manufacture the signal outputs of a number of subsets of photodetectors are characterised. During characterisation, only one of these subsets is selected to feed signals to the comparator at any one time. The subsets characterised may each relate to a different wavelength range within which to stabilise the optical output. It may then be possible for a user of the optical device to select a different subset of photodetectors from which respective signals are sent to the comparator. This would stabilise the wavelength of the optical output within a different range and provide a wavelength selectable optical device.

Alternatively the subsets characterised may relate to substantially the same wavelength range and means could be provided to alter the selected subset if a fault was found with one of the photodetectors. This would increase the reliability of the optical device.

The selection means may include contacts that must be manually soldered into place to select which photodetectors can pass signals to the comparator.

Alternatively, a logic chip may be provided which can be programmed to select the signals from the desired subset of photodetectors. The chip may be able to store and recall more than one such selection depending on the desired wavelength(s) of the optical source.

Step e) of the above method may comprise the steps of:
f) using the means for controlling the wavelength of the laser to vary the wavelength of the laser over a range including said different wavelength ranges; and
g) measuring the respective outputs from each of the photodetectors in the array as a function of wavelength as the pattern of interference fringes illuminating the array changes.

These steps allow subsets of photodetectors to be found whose response to the change in wavelength is appropriate for a desired range of wavelengths.

Preferably the selected subset of photodetectors comprises two photodetectors that produce substantially equal and opposite gradients in a plot of output signal against laser output wavelength in the selected wavelength range.

This facilitates increased sensitivity to small shifts in the wavelength of the output of the optical source.

The invention will now be further described, by way of example, with reference to the accompanying drawings, in which:
Figure 1 is a schematic diagram of a wavelength stabilised optical source comprising a laser source, an interference filter, a photodetector array, a comparator and selection means for selecting a subset of photodetectors from which corresponding signals will be sent to the comparator;
Figure 2 is a plot of the output signal response of the photodetector array as a function of the wavelength of the optical radiation emitted by the laser diode; and
Figure 3 is a plot of the output signal response of a selected subset of photodetectors from the above plot as a function of the wavelength of the optical radiation emitted by the laser diode.

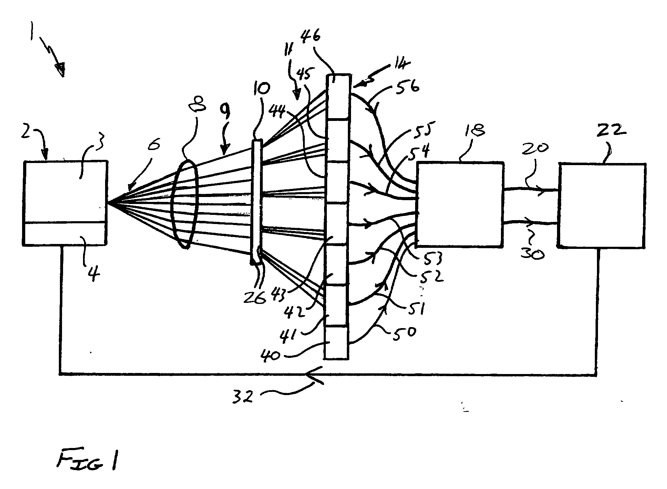

Figure 1 shows schematically a wavelength stabilised optical device 1. The device comprises an optical source 2 that includes a conventional wavelength tuneable near-infrared laser diode 3 suitable for use in fibre-optic communication. The wavelength of a laser diode 3 can be altered by, for example, changing the temperature of the laser using a thermoelectric cooler 4.

The laser diode 3 emits optical radiation 6 towards an array of photodetectors 14. A lens 8 is positioned in the optical path 6 of the laser diode 3, so that the optical radiation can be nearly collimated 9 towards an interference filter 10, in this case an etalon. The photodetector array 14 comprises at least three photodetectors 14, and in this example seven photodiodes 40-46.

Each of the photodiodes 40-46 provides a corresponding output signal 50-56 to a selection means in the form of a programmable chip 18. The chip 18 is a programmable logic array that provides two outputs 20,30 that are input to a comparator 22. The comparator 22 provides a negative feedback output signal 32 to the wavelength tuneable component 4 of the laser source 2.

The laser source 2 is capable of emitting coherent optical radiation 6 across a range of different wavelengths λ. In this example, it is desired that the laser diode 3 should provide optical radiation 6 stabilised about only one desired wavelength λ_{d}.

The optical radiation 6 emitted by the laser diode 3 is nearly collimated by the lens 8 and then projected 9 to illuminate the etalon 10, which is formed from a glass slide with partially reflecting parallel sides 26. Multiple internal reflections within the etalon 10 cause constructive and destructive interference to occur in the optical radiation passed 11 by the etalon 10. Because the optical radiation incident 9 on the etalon in not perfectly collimated, the etalon 10 projects a pattern of interference fringes 11 onto the photodetector array 14. This pattern of interference fringes is dependent upon the wavelength of the optical radiation 6 produced by the laser diode 3 and the relative positions of the laser diode 3, the lens 8 and the photodetector array 14. Each photodiode 40-46 in the array 14 produces a corresponding signal 50-56 indicative of the intensity of the optical radiation 11 incident upon it. These signals 50-56 are passed to the selection means 18.

The selection means 18 selects a subset 20,30 of two or more of these signals 50-56 for the comparator 22. The comparator compares the signals 20, 30 and generates a control signal 32 which is indicative of an error between the actual wavelength λₐ of the optical radiation 6 emitted and the desired wavelength λ_{d}. The output of the laser diode 3 is adjusted accordingly to stabilise the laser output 6 at the desired wavelength λ_{d}.

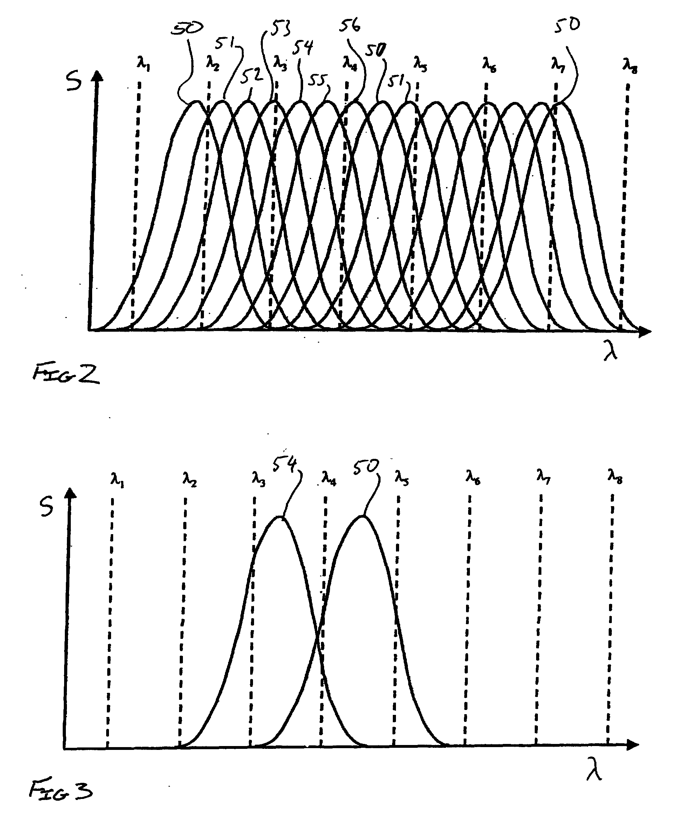

Figure 2 shows a plot of the output signal response S of the seven photodiodes 40-46 in a photodiode array 14 as a function of the wavelength λ of the optical radiation 6 emitted by a laser diode 3. As can be seen from the plot, each photodiode 40-46 generates from the interference pattern 11 a corresponding sinusoidal signal 50-56 over a different range of possible desired wavelengths, here eight wavelengths λ₁ to λ₈ that might be used in a WDM fibre-optic communication system (not shown). Here, the desired wavelength λ_{d} = λ₄. The repetitive sinusoidal pattern is due to the pattern of interference fringes 11 shifting as the wavelength λ of the optical radiation 9 incident upon the etalon 10 varies.

It will be understood that certain photodiodes 14 produce signals that are not suitable for selection as part of a subset transmitted to the comparator 22 for stabilising the wavelength output of the laser diode about certain wavelengths. For example the photodiode signal 50 would not be appropriate for stabilising the wavelength of the laser output about the wavelength λ₇, owing to the low slope in the signal at this wavelength.

Figure 3 shows the same plot as Figure 2, but in this case only the output signals 50,54 of a selected subset consisting of a pair photodiodes 40,44 is shown. In this case this pair of photodiodes is particularly suitable for stabilising the wavelength output of a laser diode about the wavelength λ₄. This pair of photodiodes 40,46 is particularly suitable for use at wavelength λ₄ because the signal characteristics 50,54 have substantially equal and opposite gradients at that wavelength. As a result, a small change in wavelength will result in a big change in the difference between the output signals 50,54. This magnification effect makes the change easier for the comparator to detect and hence makes stabilisation easier.

It will be understood that different pair of photodiodes are suitable for different values of λ.

Because it is inexpensive to provide an array 14 of photodetectors with a large number of photodiodes, the etalon 10 need only be aligned approximately with respect to the array 14, before securing the alignment, for example, with uv-curable adhesive (not shown). The final "alignment" of the interference pattern can therefore be done quickly and easily by appropriate characterisation of the movement of the interference pattern 11 over the array 14 as wavelength shifts, followed by selection using the selection means 18 of an appropriate subset of photodetectors for stabilisation about the desired wavelength.

## Claims

1. An optical wavelength control device (1), comprising a laser source (2), an interference filter (10), an array (14) of photodetectors (40-46), means for controlling the wavelength λ of the laser, and a comparator (22), in which:
i) the interference filter (10) is arranged to receive optical radiation from the laser source (2), and to project a pattern of interference fringes (11) on the photodetector array, said pattern changing according to the wavelength of optical radiation received by the interference filter (10);
ii) the comparator (22) receives from at least two of the photodetectors (40,44) corresponding signals (50,54) dependent on the pattern of interference fringes (11) on said photodetectors (40,46), and generates therefrom a control signal that varies with the wavelength of the optical radiation;
iii) the means for controlling the wavelength of the laser is responsive to the control signal to stabilise the wavelength of the optical radiation;
**characterised in that** the array (14) of photodetectors (40-46) includes at least three photodetectors, and the device (1) comprises means for choosing from amongst the array of photodetectors (40,46) a subset of photodetectors (40,44) from which the comparator (22) receives said at least two corresponding signals (20,30).

2. A device (1) as claimed in Claim 1, in which the subset of photodetectors consists of just two photodetectors (40,44).

3. A device (1) as claimed in Claim 1 or Claim 2, in which the interference filter is an etalon (10).

4. A device (1) as claimed in Claim 1 or Claim 2, in which the interference filter (10) is an interference grating.

5. A device (1) as claimed in any preceding claim, which includes a lens in the optical path from the laser source (2) to the interference filter (10) to control the divergence of the laser source (2).

6. A device (1) as claimed in Claim 5, in which the lens and the interference filter (10) are combined in a unitary structure.

7. A method for controlling the wavelength of an optical device (1), the device comprising a laser source (2), an interference filter (10), an array (14) of photodetectors (40,46), means (4) for controlling the wavelength of the laser, and a comparator (22), in which the method comprises the steps of:
a) illuminating (9) the interference filter (10) with optical radiation from the laser source (2) to project a pattern of interference fringes (11) on the photodetector array (14), said pattern (11) changing according to the wavelength λ of optical radiation received (9) by the interference filter (10);
b) using at least two of the photodetectors (40,44) to generate corresponding signals (20,30), each of said signals varying depending on the intensity of the interference fringes (11) at the corresponding photodetector (40,46);
c) providing at least two of said signals (20,30) to the comparator (22), and generating with the comparator (22) a control signal (32) that is a measure of the interference pattern (11) and hence the optical wavelength λ;
d) providing the control signal (32) to the means (4) for controlling the wavelength of the laser (3) in order to stabilise the wavelength λ of the optical radiation (6);
**characterised in that** the array of photodetectors (14) includes at least three photodetectors (40-46), and the device (1) comprises means (18) for choosing a subset (40,44) of photodetectors from amongst the array (14) of photodetectors (40,46) and the method includes the step of:
e) using the means (18) for selecting from amongst the array (14) of photodetectors (40-46) to select said subset of photodetectors (40,44) from which the comparator (22) receives said corresponding at least two signals (20,30).

8. A method as claimed in Claim 7, in which step e) is a permanent selection.

9. A method as claimed in Claim 7 or Claim 8, in which the relationship between the photodetector array (14) and the interference pattern (11) is such that different subsets of two or more photodetectors (40-46) provide corresponding signals (50-56), which, if selected to be provided to the comparator (22), result in a control signal (32) that is appropriate for stabilising the wavelength of the optical radiation within different wavelength ranges.

10. A method as claimed in Claim 9, in which step e) comprises the steps of:
f) using the means (18) for controlling the wavelength of the laser source (2) to vary the wavelength of the laser (3) over a range including said different wavelength ranges; and
g) measuring the respective outputs (50-56) from each of the photodetectors (40-46) in the array (14) as a function of wavelength λ as the pattern of interference fringes (11) illuminating the array (14) changes.

11. A method as claimed in Claim 10, in which the selected subset of photodetectors comprises two photodetectors (40,44) that produce substantially equal and opposite gradients in the plot of output signal against laser output wavelength in the selected wavelength range.
